# EUROPEAN PATENT APPLICATION

(11) **EP 2 390 911 A2**
(43) Date of publication of application: **30.11.2011**
(21) Application number: 11167207.7
(22) Date of filing: 24.05.2011
(51) Int. Cl.: H01L 23/36, H01L 23/60

(54) **Electronic device having electrically grounded heat sink and method of manufacturing the same**

(30) Priority: 26.05.2010 US 787573
(71) Applicant: LSI Corporation, Milpitas, CA 95035 (US)
(72) Inventor: Osenbach, John W., Kutztown, PA 19530 (US); Golick, Lawrence W., Nazareth, PA 18064 (US); Ickes, Robert D., Blandon, PA 19510 (US)
(74) Representative: Williams, David John

(57) **Abstract**

An electronic device includes an integrated circuit (IC) package attached to a substrate and a heat sink attached to the IC package. Additionally, the electronic device also includes a film having an electric conductivity and contacting the heat sink and the IC package and extending to the substrate to provide a grounding connection for the heat sink. A method of manufacturing an electronic device includes connecting an IC package to a substrate, coupling a heat sink to the IC package and depositing a film having an electric conductivity and contacting the heat sink and the IC package and extending to the substrate to provide a grounding connection for the heat sink.

## Description

### TECHNICAL FIELD

The present disclosure is directed, in general, to an integrated circuit and, more specifically, to an electronic device and a method of manufacturing an electronic device.

### BACKGROUND

Heat extraction from electronic devices remains an essential aspect of electronic system design. The increasing density of integration of such devices has resulted in steadily increasing power density (i.e., a quantity of power dissipated per unit area) of the electronic device. Shrinking dimensions of interconnect traces (metal lines) leads to greater sensitivity to high temperature in general, and effects such as temperature- activated electromigration are becoming of more concern. A combination of factors such as these and the related costs of mitigating them has resulted in increasing attention to heat-related system design issues on the part of electronic device and system manufacturers. Therefore, enhanced heat management approaches that provide lower implementation times and therefore costs would prove beneficial in the art.

### SUMMARY

Embodiments of the present disclosure provide an electronic device and a method of manufacturing an electronic device. In one embodiment, the electronic device includes an integrated circuit (IC) package attached to a substrate and a heat sink attached to the IC package. Additionally, the electronic device also includes a film having an electric conductivity and contacting the heat sink and the IC package and extending to the substrate to provide a grounding connection for the heat sink.

In another aspect, the present disclosure provides a method of manufacturing an electronic device including connecting an integrated circuit (IC) package to a substrate, coupling a heat sink to the IC package and depositing a film having an electric conductivity and contacting the heat sink and the IC package and extending to the substrate to provide a grounding connection for the heat sink.

The foregoing has outlined preferred and alternative features of the present disclosure so that those skilled in the art may better understand the detailed description of the disclosure that follows. Additional features of the disclosure will be described hereinafter that form the subject of the claims of the disclosure. Those skilled in the art will appreciate that they can readily use the disclosed conception and specific embodiment as a basis for designing or modifying other structures for carrying out the same purposes of the present disclosure.

### BRIEF DESCRIPTION OF THE DRAWINGS

For a more complete understanding of the present disclosure, reference is now made to the following descriptions taken in conjunction with the accompanying drawings, in which:
FIGURE 1A illustrates an electronic device showing an example of an overmolded wire bonded ball grid array (BGA) integrated circuit (IC) package employing an ungrounded external heat sink;
FIGURE 1B illustrates an electronic device showing an embodiment of an overmolded wire bonded BGA IC package employing an external heat sink having a grounding connection constructed according to the principles of the present disclosure;
FIGURE 2A illustrates an electronic device showing an example of an overmolded wire bonded BGA IC package employing an ungrounded integrated heat sink;
FIGURE 2B illustrates an electronic device showing an embodiment of an overmolded wire bonded BGA IC package employing a single heat sink having a grounding connection constructed according to the principles of the present disclosure;
FIGURE 2C illustrates an electronic device showing an embodiment of an overmolded wire bonded BGA IC package employing a combined heat sink having a grounding connection constructed according to the principles of the present disclosure;
FIGURE 3A illustrates an electronic device showing an example of an exposed die overmolded flip chip BGA IC package employing an ungrounded metal layer heat sink;
FIGURE 3B illustrates an electronic device showing an embodiment of an exposed die overmolded flip chip BGA IC package employing a single heat sink having a grounding connection constructed according to the principles of the present disclosure;
FIGURE 3C illustrates an electronic device showing an embodiment of an exposed die overmolded flip chip BGA IC package employing a combined heat sink having a grounding connection constructed according to the principles of the present disclosure;
FIGURE 4A illustrates an electronic device showing an example of an integrated heat sink flip chip BGA IC package employing an ungrounded heat sink;
FIGURE 4B illustrates an electronic device showing an embodiment of an integrated heat sink flip chip BGA IC package employing a single heat sink having a grounding connection constructed according to the principles of the present disclosure;
FIGURE 4C illustrates an electronic device showing an embodiment of an integrated heat sink flip chip BGA IC package employing a combined heat sink having a grounding connection constructed according to the principles of the present disclosure;
FIGURE 5A illustrates an electronic device showing an example of a bare die flip chip BGA IC package employing an ungrounded heat sink;
FIGURE 5B illustrates an electronic device showing an embodiment of a bare die flip chip BGA IC package employing a single heat sink having a grounding connection constructed according to the principles of the present disclosure;
FIGURE 5C illustrates an electronic device showing an embodiment of a bare die flip chip BGA IC package employing a combined heat sink having a grounding connection constructed according to the principles of the present disclosure;
FIGURE 6A illustrates an electronic device showing an example of a chip scale BGA IC package employing an ungrounded heat sink;
FIGURE 6B illustrates an electronic device showing an embodiment of a chip scale BGA IC package employing a single heat sink having a grounding connection constructed according to the principles of the present disclosure;
FIGURE 6C illustrates an electronic device showing an embodiment of a chip scale BGA IC package employing a combined heat sink having a grounding connection constructed according to the principles of the present disclosure; and
FIGURE 7 illustrates a flow diagram of an embodiment of a method of manufacturing an electronic device carried out according to principles of the present disclosure.

### DETAILED DESCRIPTION

To improve thermal management of integrated circuit (IC) packages, metal heat sinks are attached to the IC package or silicon die surface. Heat sink designs and attachment processes are typically not compatible with electrical grounding. As circuit speed increases, external electromagnetic interference can degrade the performance of a device. Electromagnetic interference may be significantly reduced by electrically connecting a metal heat sink to a device or board ground.

Cost constraints of many IC packages do not allow for insertion of a thermal sink within the IC package itself and rely on the thermal sink to be made at the circuit board level. In this case, lower cost solutions are needed for attaching electrically grounded heat sinks to the IC package. For higher- end IC packages where some additional cost can be tolerated, there are currently two techniques that provide an electrically grounded heat sink.

In a first technique for wire bond overmolded devices, an integrated heat sink may be attached to the IC package substrate using conductive epoxy. Unfortunately, such an approach has been problematic due to the fact that the conductive epoxy is hard and stiff resulting in amplified stress at the heat sink to substrate interface due to a small contact area when external pressure is applied to the device. This may lead to substrate cracks and filled area failures.

In a second technique for a heat sink for flip chip devices, the heat sink may be electrically grounded to a substrate via an electrically conductive epoxy. However, this requires a substantial substrate area of typically a few millimeters of additional space per side of the IC package. Also required is a low contact ohmic or resistance interface between the epoxy and the substrate pad. Small form factor flip chip devices such as those used in mobile phones and notebook computers typically cannot be increased in size and still fit into the small space available for them. Additionally, such grounded leads become problematic using conventional techniques. Further, as devices continue to shrink, the available space for such devices continually shrinks.

For larger devices where board space limitations are not as severe, ohmic, low resistance interfaces also become problematic. In these devices, the substrate interconnect pads (e.g., bumps) are typically made of copper with or without solder on them. Because both copper and solder form highly resistive or non-ohmic oxides when exposed to air, they do not act as a good interface connection. This problem is avoided by the incorporation of a noble metal such as gold on the pads that ground a heat sink. The requirement for two types of surface finishes on the substrate both increases the cost and the complexity of the substrate design and manufacturing process. Therefore, these substrates are neither low cost nor easily manufactured. Embodiments of the present disclosure discussed below provide solutions for achieving a low cost electrical ground for heat sinks.

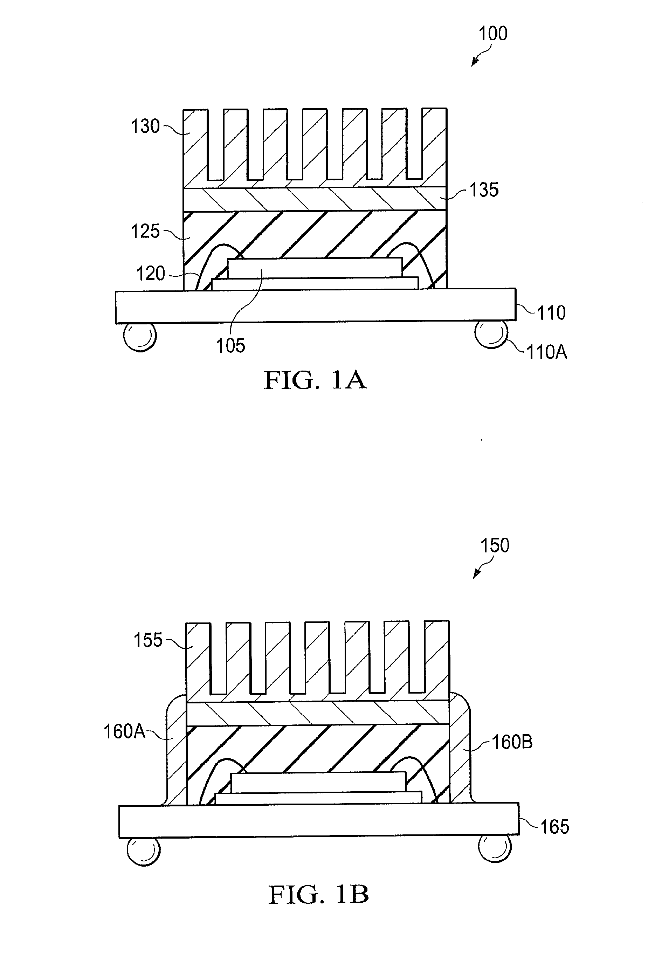

FIGURE 1A illustrates an electronic device showing an example of an overmolded wire bonded ball grid array (BGA) integrated circuit (IC) package 100 employing an ungrounded external heat sink. The overmolded wire bonded BGA IC package 100 includes an integrated circuit 105 connected to a substrate 110 wherein a circuit is connected to the integrated circuit 105. The substrate 110 is attached to a collection of solder balls, wherein a solder ball 110A is typical, for further connection of the integrated circuit 105 to another substrate such as a printed wiring board (PWB), for example. Of course, connections other than solder balls may be employed in other embodiments. A collection of wire bonds, wherein wire bond 120 is typical, is employed to connect the integrated circuit 105 to the substrate 110. An overmold compound 125 is used to encapsulate the integrated circuit 105 and the wire bonds 120, as shown. An external heat sink 130 is coupled to the overmold compound 125 through a thermal interface material 135 and thereby to the integrated circuit 105. The external heat sink 130 is subject to becoming an EMI source thereby providing a degraded performance for the integrated circuit 105.

FIGURE 1B illustrates an electronic device showing an embodiment of an overmolded wire bonded BGA IC package 150 employing an external heat sink having a grounding connection constructed according to the principles of the present disclosure. In the illustrated embodiment, the overmolded wire bonded BGA IC package 150 employs a structure corresponding to that of the overmolded wire bonded BGA IC package 100, as shown. A film 160A, 160B has an electric conductivity, contacts an external heat sink 155 of the overmolded wire bonded BGA IC package 150 and extends to a substrate 165 to provide a grounding connection for the external heat sink 155. In this case, the film 160A, 160B may be defined as a material having a thickness between 10 nm and 1 mm. More optimally, the film 160A, 160B may be between 500 nm and 0.1 mm.

In the illustrated embodiment, the film 160A, 160B comprises an electrically conducting polymer wherein the electrically conducting polymer includes a conductive second phase material such as a metal or carbon. The conductive metal may typically be silver or a silver compound if a high conductivity grounding connection is required. Alternatively, another metal may be selected and employed if a lower conductivity grounding connection is desired. In one embodiment, the electric conductively of the film 160A, 160B corresponds to about 100 mhos per centimeter. By depositing the film 160A, 160B with an ink jet sprayer, for example, electrically connecting the external heat sink 155 to a grounding point on the substrate 165 may provide a low cost electrically grounded heat sink relative to current approaches.

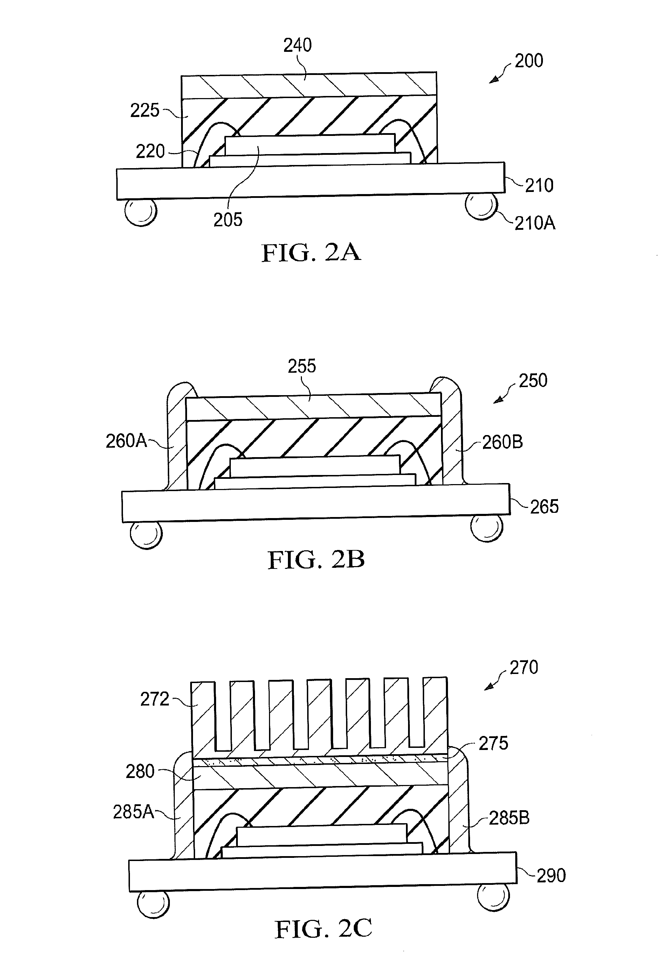

FIGURE 2A illustrates an electronic device showing an example of an overmolded wire bonded BGA IC package 200 employing an ungrounded integrated heat sink. The overmolded wire bonded BGA IC package 200 includes an integrated circuit 205 connected to a substrate 210 having a circuit connected to the integrated circuit 205. The substrate 210 is attached to a collection of solder balls, wherein a solder ball 210A is typical, for further connection of the integrated circuit 205, as discussed before. A collection of wire bonds, wherein wire bond 220 is typical, is employed to connect the integrated circuit 205 to the substrate 210. An overmold compound 225 is used to encapsulate the integrated circuit 205 and the wire bonds 220, as shown. An integrated heat sink 240 is coupled to the overmold compound 225 directly and thereby to the integrated circuit 205. The integrated heat sink 240 is subject to becoming an EMI source thereby providing a degraded performance for the integrated circuit 205, as discussed before.

FIGURE 2B illustrates an electronic device showing an embodiment of an overmolded wire bonded BGA IC package 250 employing a single heat sink having a grounding connection constructed according to the principles of the present disclosure. In the illustrated embodiment, the overmolded wire bonded BGA IC package 250 employs a structure corresponding to that of the overmolded wire bonded BGA IC package 200, as shown. A film 260A, 260B has an electric conductivity, contacts an integrated heat sink 255 of the overmolded wire bonded BGA IC package 250 and extends to a substrate 265 to provide a grounding connection for the integrated heat sink 255. The film 260A, 260B provides grounding characteristics comparable to those discussed with respect to FIGURE 1B above.

FIGURE 2C illustrates an electronic device showing an embodiment of an overmolded wire bonded BGA IC package 270 employing a combined heat sink having a grounding connection constructed according to the principles of the present disclosure. In the illustrated embodiment, the overmolded wire bonded BGA IC package 270 employs a basic structure corresponding to that of the overmolded wire bonded BGA IC package 200, as shown. The overmolded wire bonded BGA IC package 270 further includes an external heat sink 272 that is coupled thermally through a thermal interface material 275 to an integrated heat sink 280.

A film 285A, 285B has an electric conductivity, contacts the external heat sink 272 and the integrated heat sink 280 and extends to a substrate 265 to provide a grounding connection for the combined external and integrated heat sinks 272, 280. The film 260A, 260B provides grounding characteristics for the combined external and integrated heat sinks 272, 280 comparable to those discussed with respect to FIGURE 1B above.

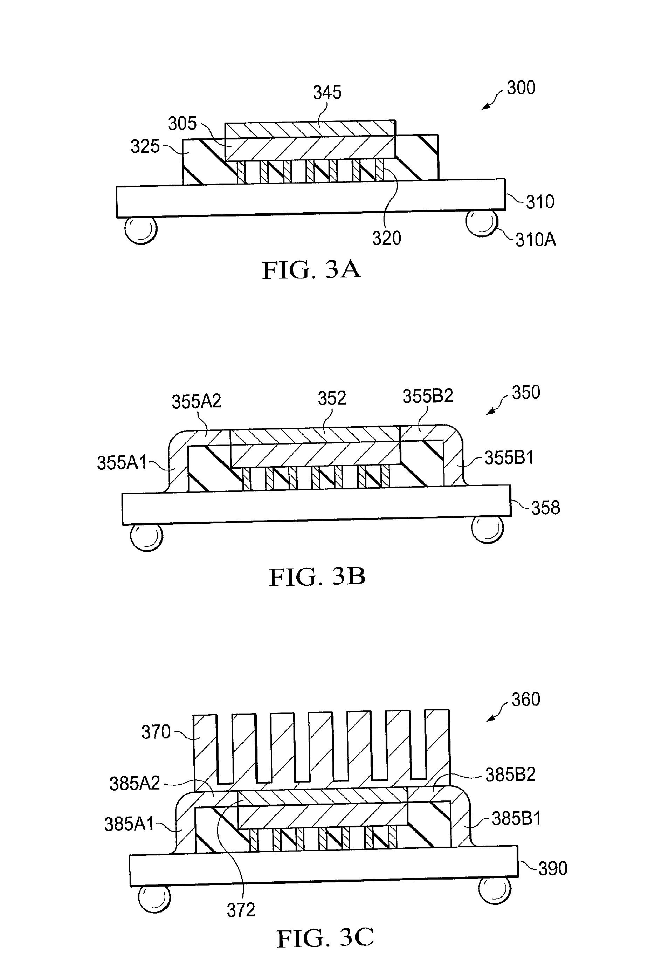

FIGURE 3A illustrates an electronic device showing an example of an exposed die overmolded flip chip BGA IC package 300 employing an ungrounded metal layer heat sink. The exposed die overmolded flip chip BGA IC package 300 includes an integrated circuit 305 connected to a substrate 310. The substrate 310 is attached to a collection of solder balls, typically indicated as solder ball 210A, for further connection of the integrated circuit 305. A collection of bumps, wherein bump 220 is typical, is employed to connect the integrated circuit 305 to the substrate 310. An overmold compound 325 is used to encapsulate the integrated circuit 305, as shown. A metal layer heat sink 345 is coupled to the integrated circuit 305 directly to form a single heat sink. The metal layer heat sink 345 is subject to becoming an EMI source thereby providing a degraded performance for the integrated circuit 205, as discussed before.

FIGURE 3B illustrates an electronic device showing an embodiment of an exposed die overmolded flip chip BGA IC package 350 employing a single heat sink having a grounding connection constructed according to the principles of the present disclosure. In the illustrated embodiment, the exposed die overmolded flip chip BGA IC package 350 employs a structure corresponding to that of the exposed die overmolded flip chip BGA IC package 300, as shown. A film 355Al, 355A2, 355B1, 355B2 has an electric conductivity, contacts a metal layer heat sink 352 of the exposed die overmolded flip chip BGA IC package 350 and extends to a substrate 358 to provide a grounding connection for the metal layer heat sink 352. The film 355Al, 355A2, 355B1, 355B2 provides grounding characteristics comparable to those discussed with respect to FIGURE 1B above.

FIGURE 3C illustrates an electronic device showing an embodiment of an exposed die overmolded flip chip BGA IC package 360 employing a combined heat sink having a grounding connection constructed according to the principles of the present disclosure. In the illustrated embodiment, the exposed die overmolded flip chip BGA IC package 360 employs a basic structure corresponding to that of the exposed die overmolded flip chip BGA IC package 300, as shown. The exposed die overmolded flip chip BGA IC package 360 further includes an external heat sink 370 that is coupled directly to a metal layer heat sink 372.

A film 385A1, 385A2, 285B1, 385B2 has an electric conductivity, contacts the external heat sink 370 and the metal layer heat sink 372 and extends to a substrate 390 to provide a grounding connection for the combined external and metal layer heat sinks 370, 372. The film 385A1, 385A2, 285B1, 385B2 provides grounding characteristics comparable to those discussed with respect to FIGURE 1B above.

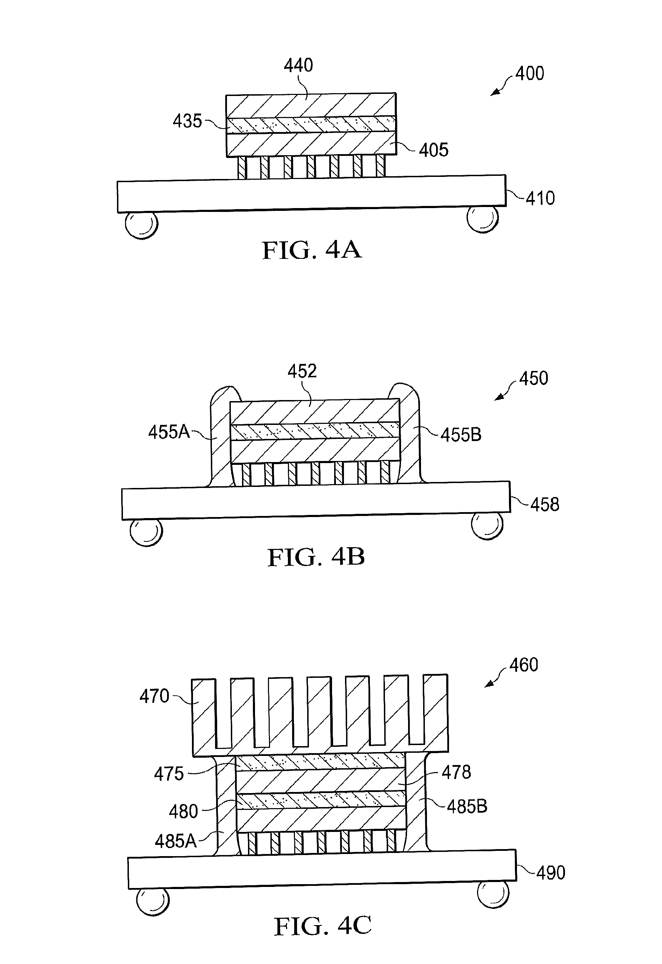

FIGURE 4A illustrates an electronic device showing an example of an integrated heat sink flip chip BGA IC package 400 employing an ungrounded heat sink. The integrated heat sink flip chip BGA IC package 400 includes an integrated circuit 405 connected to a substrate 410. An integrated heat sink 440 is coupled through a thermal interface material 435 to the integrated circuit 405 to form a single heat sink. The integrated heat sink 440 is subject to becoming an EMI source, as before.

FIGURE 4B illustrates an electronic device showing an embodiment of an integrated heat sink flip chip BGA IC package 450 employing a single heat sink having a grounding connection constructed according to the principles of the present disclosure. In the illustrated embodiment, the integrated heat sink flip chip BGA IC package 450 employs a structure corresponding to that of the integrated heat sink flip chip BGA IC package 400, as shown. A film 455A, 455b has an electric conductivity, contacts an integrated heat sink 452 of the integrated heat sink flip chip BGA IC package 400 and extends to a substrate 458 to provide a grounding connection for the integrated heat sink 452. The film 455A, 455b provides grounding characteristics comparable to those discussed with respect to FIGURE 1B above.

FIGURE 4C illustrates an electronic device showing an embodiment of an integrated heat sink flip chip BGA IC package 460 employing a combined heat sink having a grounding connection constructed according to the principles of the present disclosure. In the illustrated embodiment, the integrated heat sink flip chip BGA IC package 460 employs a basic structure corresponding to that of the integrated heat sink flip chip BGA IC package 400, as shown. The integrated heat sink flip chip BGA IC package 460 further includes an external heat sink 470 that is coupled through a thermal interface material 475 to an integrated heat sink 478 to form a combined external and integrated heat sink 475, 478. A film 485A, 485B has an electric conductivity, contacts the external heat sink 470 and the integrated heat sink 478 and extends to a substrate 490 to provide a grounding connection for the combined external and integrated heat sink 475, 478. The film 485A, 485B provides grounding characteristics comparable to those discussed with respect to FIGURE 1B above.

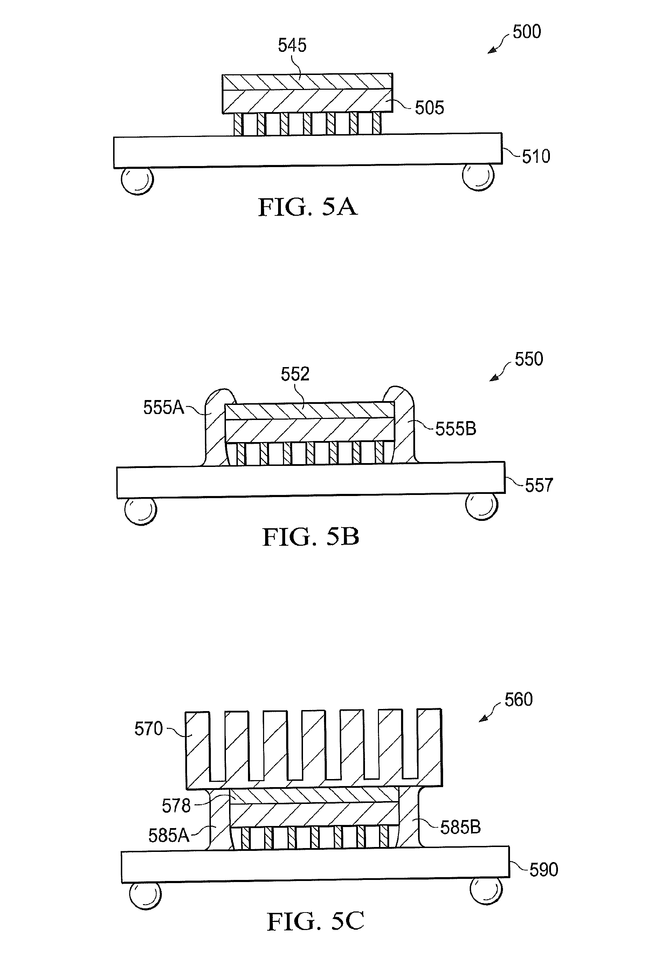

FIGURE 5A illustrates an electronic device showing an example of a bare die flip chip BGA IC package 500 employing an ungrounded heat sink. The integrated heat sink flip chip BGA IC package 500 includes an integrated circuit 505 connected to a substrate 510. A metal layer heat sink 545 is coupled directly the integrated circuit 505 to form a single heat sink. The metal layer heat sink 545 is subject to becoming an EMI source, as before.

FIGURE 5B illustrates an electronic device showing an embodiment of a bare die flip chip BGA IC package 550 employing a single heat sink having a grounding connection constructed according to the principles of the present disclosure. In the illustrated embodiment, the bare die flip chip BGA IC package 550 employs a structure corresponding to that of the bare die flip chip BGA IC package 500, as shown. A film 555A, 555b has an electric conductivity, contacts a metal layer heat sink 552 of the bare die flip chip BGA IC package 550 and extends to a substrate 557 to provide a grounding connection for the metal layer heat sink 552. The film 555A, 555b provides grounding characteristics comparable to those discussed with respect to FIGURE 1B above.

FIGURE 5C illustrates an electronic device showing an embodiment of a bare die flip chip BGA IC package 560 employing a combined heat sink having a grounding connection constructed according to the principles of the present disclosure. In the illustrated embodiment, the bare die flip chip BGA IC package 560 employs a basic structure corresponding to that of the bare die flip chip BGA IC package 500, as shown. The bare die flip chip BGA IC package 560 further includes an external heat sink 570 that is coupled directly to a metal layer heat sink 578 to form a combined external and metal layer heat sink 570, 578. A film 585A, 585B has an electric conductivity, contacts the external heat sink 570 and the metal layer heat sink 578 and extends to a substrate 590 to provide a grounding connection for the combined external and metal layer heat sink 470, 578. The film 585A, 585B provides grounding characteristics comparable to those discussed with respect to FIGURE 1B above.

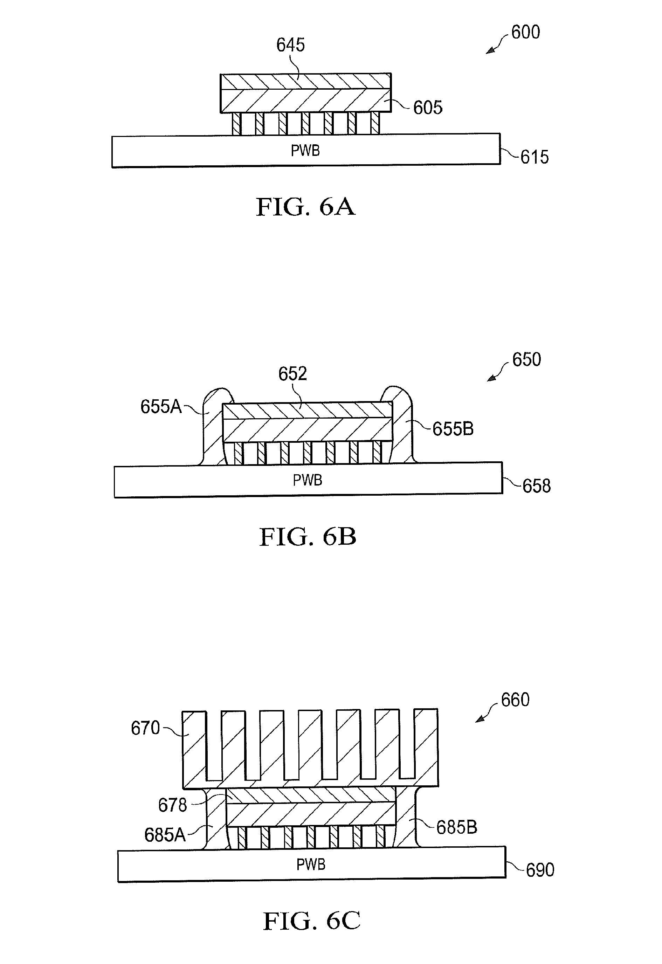

FIGURE 6A illustrates an electronic device showing an example of a chip scale BGA IC package 600 employing an ungrounded heat sink. The scale BGA IC package 600 includes an integrated circuit 605 connected to a printed wiring board (PWB) substrate 610. A metal layer heat sink 645 is coupled directly the integrated circuit 605 to form a single heat sink. The metal layer heat sink 645 is subject to becoming an EMI source, as before.

FIGURE 6B illustrates an electronic device showing an embodiment of a chip scale BGA IC package 650 employing a single heat sink having a grounding connection constructed according to the principles of the present disclosure. In the illustrated embodiment, the chip scale BGA IC package 650 employs a structure corresponding to that of the chip scale BGA IC package 600, as shown. A film 655A, 655b has an electric conductivity, contacts a metal layer heat sink 652 of the chip scale BGA IC package 650 and extends to a PWB substrate 658 to provide a grounding connection for the metal layer heat sink 652. The film 655A, 655b provides grounding characteristics comparable to those discussed with respect to FIGURE 1B above.

FIGURE 6C illustrates an electronic device showing an embodiment of a chip scale BGA IC package 660 employing a combined heat sink having a grounding connection constructed according to the principles of the present disclosure. In the illustrated embodiment, the chip scale BGA IC package 660 employs a basic structure corresponding to that of the chip scale BGA IC package 600, as shown. The chip scale BGA IC package 660 further includes an external heat sink 670 that is coupled directly to a metal layer heat sink 678 to form a combined external and metal layer heat sink 670, 678. A film 685A, 685B has an electric conductivity, contacts the external heat sink 670 and the metal layer heat sink 678 and extends to a PWB substrate 690 to provide a grounding connection for the combined external and metal layer heat sink 670, 678. The film 685A, 685B provides grounding characteristics comparable to those discussed with respect to FIGURE 1B above.

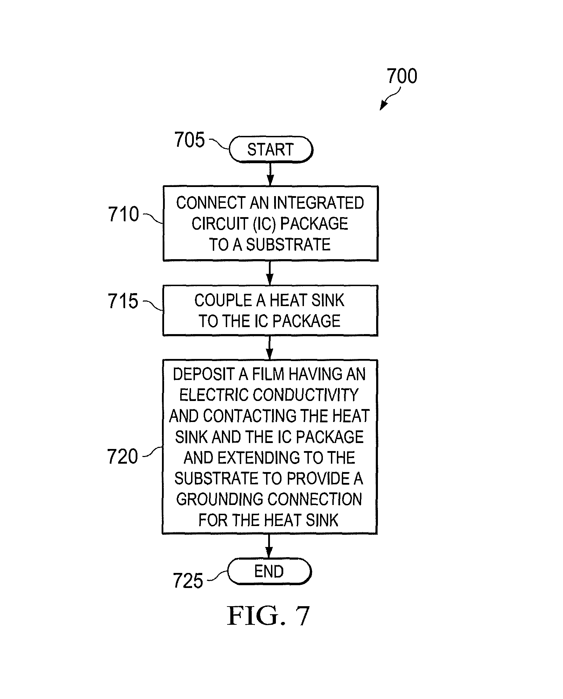

FIGURE 7 illustrates a flow diagram of an embodiment of a method of manufacturing an electronic device, generally designated 700, carried out according to principles of the present disclosure. The method 700 starts in a step 705. Then, an integrated circuit (IC) package is connected to a substrate, in a step 710, and a heat sink is coupled to the IC package, in a step 715.

In one embodiment, coupling the heat sink comprises coupling a single heat sink corresponding to an integrated heat sink, an external heat sink or a metal layer of the IC package. In another embodiment, coupling the heat sink comprises coupling a combined heat sink corresponding to at least two of an external heat sink, an integrated heat sink and a metal layer of the IC package. In yet another embodiment, coupling the heat sink comprises coupling a metal layer directly to the IC package. In a further embodiment, coupling the heat sink comprises coupling the heat sink to a mold compound that at least partially encapsulates the IC package. In still another embodiment, coupling the heat sink comprises placing a thermal interface material between the heat sink and the IC package.

A film having an electric conductivity and contacting the heat sink and the IC package and extending to the substrate is deposited to provide a grounding connection for the heat sink, in a step 720. In one embodiment depositing the film comprises depositing an electrically conducting polymer having a conductive metal therein. In another embodiment, depositing the film comprises the electric conductively corresponding to about 100 mhos per centimeter. In yet another embodiment, depositing the film comprises depositing the film with an ink jet sprayer.

In still another embodiment, depositing the film comprises depositing to at least a portion of the IC package selected from the group consisting of an overmolded wire bonded ball grid array (BGA) package, an exposed die overmolded flip chip BGA package, an integrated heat sink flip chip BGA package, a bare die flip chip BGA package and a chip scale BGA package. The method 700 ends in a step 725.

While the method disclosed herein has been described and shown with reference to particular steps performed in a particular order, it will be understood that these steps may be combined, subdivided, or reordered to form an equivalent method without departing from the teachings of the present disclosure. Accordingly, unless specifically indicated herein, the order or the grouping of the steps is not a limitation of the present disclosure.

Those skilled in the art to which the disclosure relates will appreciate that other and further additions, deletions, substitutions and modifications may be made to the described example embodiments without departing from the disclosure.

## Claims

1. An electronic device, comprising:
an integrated circuit (IC) package attached to a substrate;
a heat sink attached to the IC package; and
a film having an electric conductivity and contacting the heat sink and the IC package and extending to the substrate to provide a grounding connection for the heat sink.

2. The electronic device as recited in Claim 1 wherein the film comprises an electrically conducting polymer.

3. The electronic device as recited in Claim 1 wherein the film is connected to at least a portion of the IC package selected from the group consisting of:
an overmolded wire bonded ball grid array (BGA) package;
an exposed die overmolded flip chip BGA package;
an integrated heat sink flip chip BGA package;
a bare die flip chip BGA package; and
a chip scale BGA package.

4. The electronic device as recited in Claim 1 wherein the heat sink is a combined heat sink corresponding to at least two of an external heat sink, an integrated heat sink and a metal layer of the IC package.

5. The electronic device as recited in Claim 1 wherein the heat sink is coupled to a mold compound that encapsulates at least a portion of the IC package.

6. A method of manufacturing an electronic device, comprising:
connecting an integrated circuit (IC) package to a substrate;
coupling a heat sink to the IC package;
depositing a film having an electric conductivity and contacting the heat sink and the IC package and extending to the substrate to provide a grounding connection for the heat sink.

7. The method as recited in Claim 6 wherein depositing the film comprises depositing the film with an ink jet sprayer.

8. The method as recited in Claim 7 wherein depositing the film comprises depositing an electrically conducting polymer having a conductive metal therein.

9. The method as recited in Claim 6 wherein depositing the film comprises depositing to at least a portion of the IC package selected from the group consisting of:
an overmolded wire bonded ball grid array (BGA) package;
an exposed die overmolded flip chip BGA package;
an integrated heat sink flip chip BGA package;
a bare die flip chip BGA package; and
a chip scale BGA package.

10. The method as recited in Claim 6 wherein coupling the heat sink comprises coupling a combined heat sink corresponding to at least two of an external heat sink, an integrated heat sink and a metal layer of the IC package.
